## Europäisches Patentamt
## European Patent Office
## Office européen des brevets

(11) Numéro de publication: **0 337 869**
**A1**

# (12) DEMANDE DE BREVET EUROPEEN

(21) Numéro de dépôt: **89400979.4**

(22) Date de dépôt: **10.04.89**

(51) Int. Cl.⁴: **G 11 C 19/28**

(30) Priorité: **12.04.88 FR 8804814**

(43) Date de publication de la demande:
**18.10.89 Bulletin 89/42**

(84) Etats contractants désignés: **DE GB IT NL**

(71) Demandeur: **COMMISSARIAT A L'ENERGIE ATOMIQUE**
**31/33, rue de la Fédération**
**F-75015 Paris (FR)**

(72) Inventeur: **Audaire, Luc**
**14, Rue du Docteur Mazet**
**F-38000 Grenoble (FR)**

**Cluzel, Jacques**
**1, Boulevard de Jomardière**
**F-38120 Saint Egrève (FR)**

**Pantigny, Philippe**
**4, Avenue Albert 1er de Belgique**
**F-38100 Grenoble (FR)**

(74) Mandataire: **Mongrédien, André et al**
**c/o BREVATOME 25, rue de Ponthieu**
**F-75008 Paris (FR)**

(54) **Procédé de lecture pour un dispositif à transfert de charge et étage de sortie de lecture d'un tel dispositif.**

(57) L'invention concerne un procédé de lecture d'un dispositif à transfert de chargé et l'étage de sortie d'un tel dispositif, le procédé consistant à effectuer la lecture en deux étapes :
- une première étape de transfert du signal de charge sur l'élément qui va servir à lire ce signal,
- une deuxième étape de lecture proprement dite de ce signal de charge sur cet élément dès que ce signal est établi en sortie de l'étage suiveur,
le procédé étant caractérisé en ce qu'il consiste à appliquer une tension d'alimentation impulsionnelle (φVDD) sur l'étage suiveur de l'étage de sortie de manière à ce que cet étage ne soit alimenté par cette tension impulsionnelle VDD que lorsque chacune des deux étapes constitue une lecture.
Application aux dispositifs à transfert de charge.

FIG. 5

EP 0 337 869 A1

## Description

# PROCEDE DE LECTURE POUR UN DISPOSITIF A TRANSFERT DE CHARGE ET ETAGE DE SORTIE DE LECTURE D'UN TEL DISPOSITIF

La présente invention concerne un procédé de lecture pour un dispositif à transfert de charge et l'étage de sortie de lecture dudit dispositif.

On désigne habituellement les dispositifs à transfert de charge par l'abréviation française DTC ou par l'abréviation anglo-saxonne CCD. On utilise de tels circuits DTC dans les domaines de l'imagerie dans lesquels ils sont employés en tant que capteurs optiques ou en tant que circuits de lecture couplés aux capteurs.

La lecture du signal correspondant à des charges stockées sous la dernière grille de stockage du circuit DTC s'effectue à partir d'un étage de sortie dans lequel on procède habituellement selon les deux principes les plus couramment employés que l'on rappelle ci-dessous :

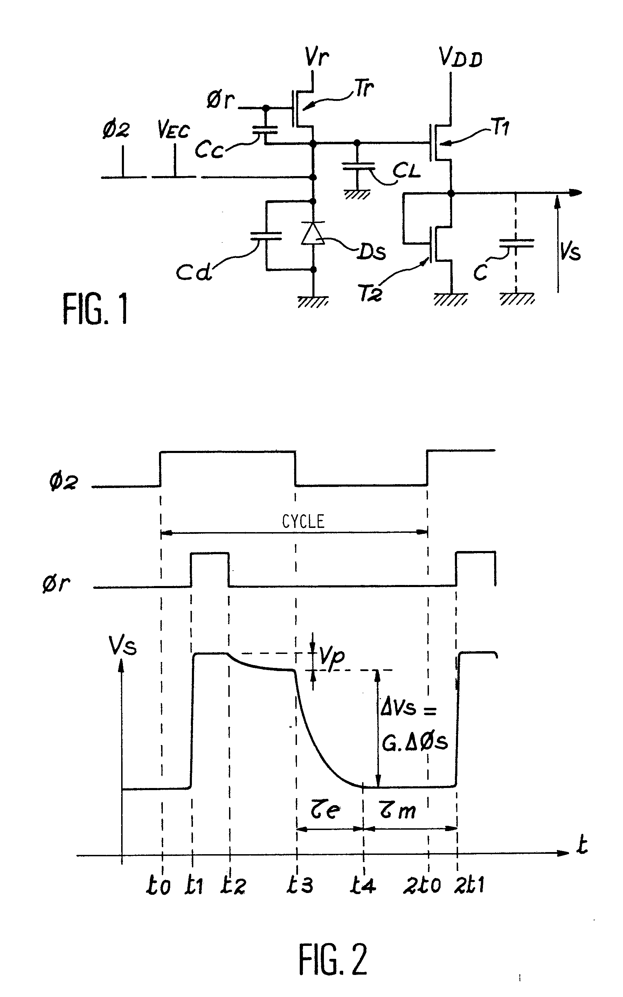

Le premier principe consiste à effectuer la lecture sur diode flottante. L'étage de sortie basé sur ce premier principe est représenté sur la figure 1. Les signaux de phase et la tension de sortie de cet étage sont représentés sur la figure 2.

La lecture s'opère en deux étapes.

Une diode DS permet de recevoir la charge signal stockée sous la dernière électrode de stockage (grille) qui est reliée à un signal de phase $\varphi_2$. Pour cela, dans une première étape, la diode DS est préchargée par un transistor TR dont la grille est commandée par un signal de phase $\varphi_R$ et dont le drain est relié à une tension continue VR qui est éventuellement égale à la tension d'alimentation VDD du circuit DTC. La diode DS est donc préchargée à une valeur de référence avant de recevoir la charge signal. Pendant la durée d'un cycle de la phase signal $\varphi_2$, c'est-à-dire, entre les instants $t_0$ et $2t_0$, une charge se trouve sous la grille qui est reliée à cette phase $\varphi_2$.

A un instant $t_1$, situé pendant la première demi-période de la phase $\varphi_2$, la phase $\varphi_R$ est portée à un potentiel haut, le transistor MOS TR est alors passant et la diode DS est portée au potentiel de recharge. Ce potentiel de recharge est égal à VR dans le cas où VR est supérieur ou égal au signal de phase $\varphi_R$ moins la tension de seuil du transistor MOS de recharge TR, (VR $\geq$ V$\varphi_R$ -VT). Le potentiel de recharge est égal à V$\varphi_R$ -VT, c'est-à-dire au signal de phase $\varphi_R$ moins la tension de seuil du transistor TR dans le cas où la tension VR est inférieure ou égale à cette dernière (VR $\leq$ V$\varphi_R$-VT) ; la tension V$\varphi_R$ représente le potentiel haut du signal de phase $\varphi_R$.

Ensuite et selon une deuxième étape, le signal de phase $\varphi_R$ revient à son potentiel bas, c'est-à-dire pratiquement à l'instant $t_2$ représenté sur la figure 2, les charges signal sont alors transférées sur la diode DS par dessus la barrière de potentiel induite par l'électrode qui est reliée à une tension fixe VEC.

A cet instant $t_2$, le potentiel de la diode DS décroît d'une quantité VP correspondant à une tension de décalage (OFFSET). Cette tension de décalage est introduite par le couplage parasite dû à la liaison capacitive parasite Cc présente entre la grille du transistor TR et la diode DS, avec la liaison capacitive Cd de la diode DS et la liaison capacitive CL de connexion entre la diode DS et le transistor MOS $T_1$ de l'étage suiveur (formé des transistors $T_1$ et $T_2$).

C'est pratiquement à l'instant $t_3$ qu'a lieu réellement l'arrivée des charges signal. Ces charges font décroître progressivement le potentiel de la sortie VS pendant une durée $\tau_e$ liée au produit $R_{ON2}.C$, d'une quantité $\Delta\varphi_s$, $T_{ON2}$ étant la résistance du transistor T2 en fonctionnement et C la capacité de sortie.

Si G est le gain de l'étage suiveur de sortie, la variation $\Delta\varphi_s$ se traduit en sortie par une variation $\Delta V_s$ égale à $G\Delta\varphi_s$.

La tension de sortie n'est donc mesurable que pendant une durée $\tau_m$ qui est limitée par la durée d'établissement $\tau_e$. La durée $\tau_e$ ne peut être réduite sous peine d'augmenter la puissance consommée.

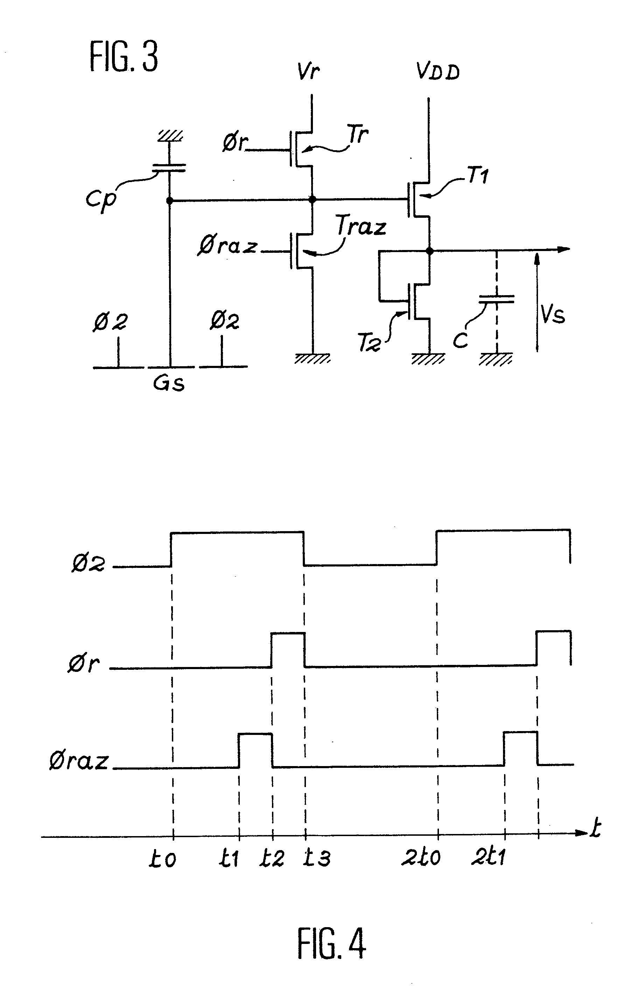

Le deuxième principe est basé sur la lecture sur une grille flottante. Le schéma de principe est représenté sur la figure 3. Les différents signaux de phase sont représentés sur la figure 4. La différence essentielle avec le principe précédent réside dans le fait que la diode DS est remplacée par une grille flottante GS.

La lecture s'opère également en deux étapes. L'électrode de stockage Gs au lieu d'être reliée à la phase $\varphi_2$ est commandée par deux transistors MOS TR et TRAZ qui effectuent respectivement une précharge avant l'arrivée du signal de charge et une remise à zéro pour l'évacuation du signal sous l'étage suivant.

Au moment de l'arrivée du signal, l'électrode Gs est laissée flottante et son potentiel est lu par les deux transistors MOS $T_1$ et $T_1$ montés en suiveur.

Le processus de fonctionnement est similaire à celui décrit précédemment si ce n'est qu'après la lecture des charges une remise à zéro de la grille flottante est nécessaire pour l'évacuation des charges. Cette remise à zéro est effectuée par le transistor TRAZ dont la grille est reliée au signal de phase $\varphi$RAZ active entre les instants $t_1$ et $t_2$ qui permet d'évacuer les charges qui ont été lues lors du cycle précédent.

Lors de l'arrivée des charges signal, la grille flottante Gs voit son potentiel varier d'une quantité $\Delta\varphi_s$. Pour un dispositif DTC à canal de surface, on peut donc écrire que :

$$\Delta\phi_s = -\frac{Q_e}{C_p} - \frac{C_L}{C_p} \cdot K_B \cdot \left( \sqrt{\phi_s} - \sqrt{\phi_{s0}} \right)$$

$C_L$ étant la capacité d'oxyde de la grille Gs, $C_p$ les capacités de connexion sur la grille Gs, $Q_e$ la charge signal, $K_B$ le coefficient dépendant de paramètres technologiques, $\varphi_s$ et $\varphi_{s0}$ des potentiels de surface sous la grille Gs respectivement entre les instants $t_1$ et $t_2$, $t_3$ et $2t_0$.

Cette variation de potentiel $\varphi_s$ est lue à l'aide de l'étage suiveur formé par les transistors MOS $T_1$ et $T_2$, étage similaire à celui qui a été décrit à propos de la figure 1. Le signal de sortie et $\Delta Vs = Gx\Delta\varphi_s$, où G est le gain de l'étage suiveur. Ces deux principes de mesure présentent un inconvénient majeur.

Cet inconvénient vient du fait que le signal en sortie, c'est-à-dire $\Delta Vs$, n'est mesurable qu'entre les instants $t_4$ d'une période de la phase $\varphi_2$ et l'instant $2t_1$ si on conserve la même origine des temps, soit l'instant $t_1$ de la période suivante. Ce signal n'est donc mesurable qu'après les intervalles de temps $t_3$, $t_4$ correspondant à la durée d'établissement $\tau e$.

En première approximation, ce temps d'établissement $\tau e$ est limité comme cela a déjà été dit, par le produit $R_{ON2}.C$ dans lequel $R_{ON2}$ représente la résistance lorsque le transistor T2 est en fonction, et C la capacité parasite à la sortie de l'étage. Pour minimiser le temps $\tau e$, il convient donc de diminuer la résistance de fonctionnement du transistor T2 et ceci d'autant plus que la cadence de sortie du circuit DTC est grande pour conserver une durée de mesure $\tau m$ suffisante.

Par ailleurs, la puissance dissipée dans les transistors suiveurs T1 et T2 possède deux composantes, une composante statique et une composante dynamique. La composante statique est prépondérante et est dissipée en permanence si bien qu'il est nécessaire de trouver un compromis entre la cadence de sortie des signaux et la puissance dissipée et plus exactement entre la fréquence des variations que subit cet étage suiveur qui est égale à deux fois la fréquence de sortie du signal et la consommation du circuit.

En effet, plus la fréquence de sortie du signal est élevée, plus la charge de sortie (transistor T2 ou résistance équivalente) doit être faible et plus la puissance dissipée est élevée.

On rappelle que la composante statique Pstatique est égale à VDD.I, où I représente le courant moyen traversant les transistors $T_1$ et $T_2$, I étant donc égal à $Vs/R_{ON2}$.

On rappelle par ailleurs que la composante dynamique liée aux variations Vs du signal aux bornes de la capacité C est égale à Pdynamique soit $1/2.C.(\Delta Vs)^2.F$ où F est la fréquence des variations.

La présente invention a donc pour objet un procédé de lecture d'un dispositif à transfert de charge et un étage de sortie de lecture d'un tel dispositif qui permettent de résoudre ces problèmes et qui permettent par conséquent de repousser le compromis fréquence-consommation lors de la lecture du signal de charge du dispositif.

L'invention a donc pour objet un procédé de lecture d'un dispositif à transfert de charge alimenté par une tension continue VDD et comportant un étage de sortie comprenant un élément sur lequel est transféré un signal de charge et un étage suiveur, la lecture s'opérant en deux étapes :
- une première étape de transfert du signal de charge sur l'élément qui va servir à lire ce signal,
- une deuxième étape de lecture proprement dite de ce signal de charge sur cet élément dès que ce signal est établi en sortie de l'étage suiveur ;
ledit procédé étant caractérisé en ce qu'il consiste à appliquer une tension d'alimentation impulsionnelle sur l'étage suiveur de manière à ce que cet étage ne soit alimenté par cette tension impulsionnelle $\varphi VDD$ que lors de chacune des deux étapes constituant une lecture.

Avantageusement, la tension impulsionnelle est un signal de phase $\varphi VDD$ obtenu à partir de la tenion d'alimentation VDD.

L'invention a également pour objet un dispositif à transfert de charge comprenant un élément sur lequel est transféré un signal de charge destiné à être lu, et un étage suiveur qui permet la lecture de ce signal et qui comporte un premier transistor MOS $T_1$ monté en source suiveuse et un deuxième transistor MOS $T_2$ de charge, caractérisé en ce que cet étage suiveur est alimenté par un signal de phase VDD obtenu à partir de la tension d'alimentation VDD de l'ensemble du dispositif.

Avantageusement, le transistor de charge $T_2$ est choisi de manière à avoir une résistance de fonctionnement supérieure à celle du transistor $T_1$ et supérieure au transistor de charge habituellement utilisé, ce qui permet de réduire la puissance dissipée sans que pour cela la durée de présence du signal de charge à la sortie de cet étage soit insuffisante.

La présente invention sera mieux comprise à l'aide de la description détaillée faite à titre d'exemple non limitatif et en regard des figures annexées qui représentent :
- la figure 1, un schéma de l'étage de sortie permettant la lecture sur diode flottante selon l'art antérieur,
- la figure 2, les diagrammes des signaux de phase et du signal de sortie en fonction du temps dans le cas d'une lecture selon les méthodes de l'art antérieur,
- la figure 3, le schéma d'un étage de sortie dans le cas d'une lecture sur grille flottante,
- la figure 4, les diagrammes des signaux de phase selon ce principe de lecture et selon une méthode relative à l'art antérieur, - la figure 5, un étage de sortie de lecture sur diode flottante d'après le procédé conforme à l'invention,
- la figure 6, les diagrammes des signaux de phase et le signal de sortie en fonction du temps, d'après le procédé conforme à l'invention.

Les figures 1 à 4, relatives à l'art antérieur, ont déjà été décrites. Dans toute la description les mêmes éléments portent les mêmes références.

Le procédé selon l'invention s'applique tout aussi bien au dispositif DTC ayant un étage de sortie basé sur le principe de la lecture sur diode flottante qu'au dispositif DTC ayant un étage de sortie basé sur la lecture sur grille flottante. Seul le schéma d'un dispositif basé sur le principe de la lecture d'une diode flottante a été représenté à titre d'exemple.

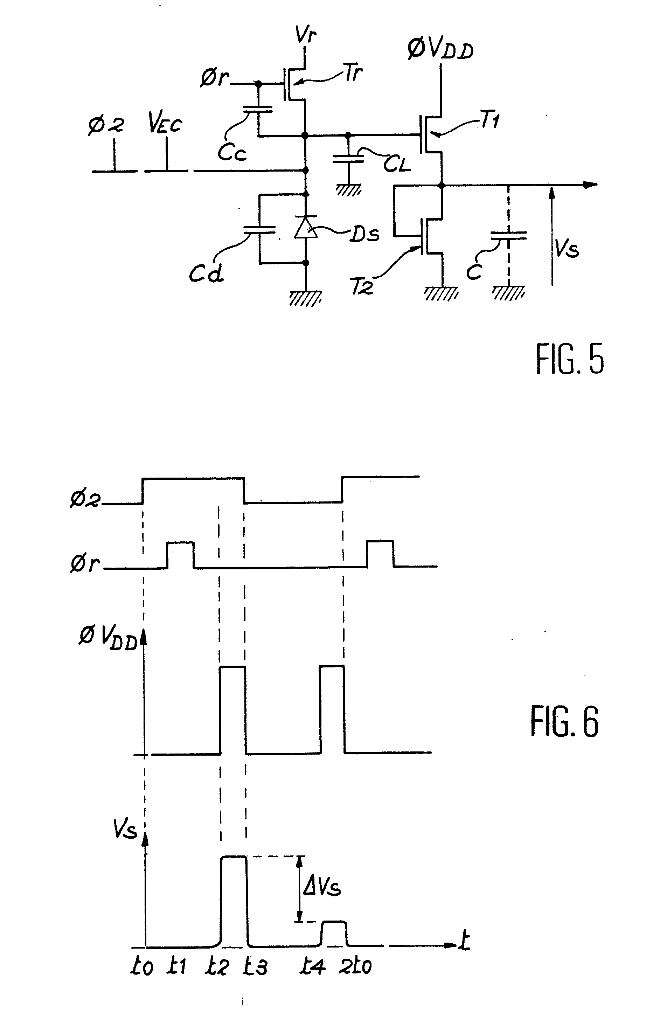

On a donc représenté sur la figure 5 un étage de sortie d'un dispositif DTC basé sur le principe de la lecture sur diode flottante. Le procédé selon l'invention consiste à appliquer un signal de phase obtenu à partir de la tension d'alimentation VDD sur cet étage de sortie au lieu de lui appliquer la tension continue VDD.

La tension d'alimentation de cet étage de sortie est donc une tension d'alimentation impulsionnelle représentée par le signal de phase $\varphi VDD$ sur la figure 6. Les signaux de phase $\varphi_2$ et $\varphi_R$ sont inchangés par rapport aux signaux utilisés dans l'art antérieur. Ce signal de phase $\varphi VDD$ permet donc d'alimenter l'étage de sortie uniquement pendant la durée des deux étapes qui constituent une lecture d'un signal de charge stocké sur la dernière électrode reliée au signal de phase $\varphi_2$ d'un circuit DTC.

La première étape de lecture se produit lorsque le signal de phase $\varphi_2$ revient à son potentiel bas, c'est-à-dire à l'instant $t_3$, les charges signal sont alors transférées sur la diode DS par dessus la barrière de potentiel induite par la tension continue VEC, la diode DS ayant été portée à un potentiel de recharge pendant la phase $\varphi_R$.

L'alimentation de l'étage de sortie par le signal phase $\varphi DD$ permet d'appliquer le potentiel VDD entre les instants $t_2$ et $t_3$, c'est-à-dire pendant le transfert des charges signal sur la diode DS. Dès l'application du signal de phase $\varphi VDD$ à l'instant $t_4$, les charges signal qui sont arrivées sur la diode DS et qui ont fait décroître son potentiel d'une valeur $\Delta Vs = G\Delta\varphi_s$ sont mesurables à l'étage de sortie.

L'invention consiste donc en une alimentation impulsionnelle de l'étage de sortie, cette alimentation est réalisée par un signal de phase $\varphi VDD$ et est obtenue dé manière classique au moyen de l'alimentation générale VDD. L'alimentation de l'étage suiveur de sortie n'est établie que lors de la lecture du signal. A l'instant $t_2$, le signal de charge s'établit au niveau de recharge, à l'instant $t_4$ elle s'établit au niveau sortie de signal.

L'utilisation d'une alimentation pulsée permet d'améliorer considérablement le couple fréquence de sortie/puissance dissipée.

En effet, dans le cas où l'on choisit un transistor $T_2$ ayant une résistance en fonctionnement grande, la lecture selon les méthodes antérieures ne pourra pas être effectuée car le temps d'établissement du signal de charge au niveau sortie de signal sera trop important pour que la mesure puisse être effectuée. Si au contraire on choisit un transistor de charge $T_2$ présentant une résistance assez faible, c'est la puissance dissipée qui devient importante car, comme cela a déjà été décrit, cette puissance comporte une composante statique Pstatique qui est proportionnelle au courant moyen traversant les transistors $T_1$ et $T_2$ à la tension d'alimentation VDD si bien que si l'on choisit un transistor $T_2$ présentant une résistance $R_{ON2}$ faible, le courant augmente et par conséquent la puissance augmente également.

Comme la durée d'établissement du signal dans le procédé de lecture selon l'invention est instantanée quasiment puisque cette durée correspond au temps de montée du niveau signal $\Delta Vs$ représenté sur la figure 6, on peut donc, grâce au procédé de lecture selon l'invention, utiliser un transistor de charge $T_2$ présentant une résistance plus importante que celle utilisée dans l'art antérieur.

Pour une fréquence de sortie fixée, on peut donc accroître considérablement la résistance de charge $R_{ON2}$ du transistor $T_2$, ce qui a pour avantage :

- de réduire la puissance statique dissipée qui est la puissance prépondérante $VDD.Vs/R_{ON2}$,

- d'accroître le gain de l'étage de sortie car ce gain est inversement proportionnel à la caractéristique géométrique de la résistance du transistor $T_2$ et que cette caractéristique géométrique est faible lorsque la résistance est grande,

- de bénéficier du gain capacitif de recharge car lorsqu'on effectue la recharge de la diode DS (ou de la grille Gs) avec la tension VDD nulle, cette recharge se fait sur une capacité :

$$C_{s1} = C_L + C_p + C_{ox}.\gamma$$

qui est supérieure à la capacité :

$$C_{s2} = C_L + C_p + 2/3C_{ox}.\gamma\ (1-G)$$

lors de la lecture.

On peut donc recharger à un niveau supérieur au niveau de recharge obtenu avec une tension d'alimentation VDD continue.

Dans l'hypothèse d'un bruit de recharge $u_B = (kT/C)^{1/2}$, le fait de recharger sur la capacité $C_{s1}$ permet également de réduire le bruit de recharge de cet étage de lecture, $C_{s1}$ étant supérieur à $C_{s2}$.

Deux exemples numériques vont être donnés dans ce qui suit afin d'illustrer les avantages de la présente invention. Ces exemples ne doivent pas être interprétés comme une limitation de l'invention, mais doivent être pris à titre purement illustratif.

Dans l'hypothèse d'une capacité de sortie $C = 20pF$ et d'une alimentation $VDD = 15V$, on obtient les résultats suivants :

a)- pour une alimentation VDD continue si l'on choisit un transistor $T_2$ tel que sa résistance $R_{ON2}$ est égale à 2 kΩ, et dans l'hypothèse où le transistor $T_1$ fonctionne en régime de saturation tout le long du temps d'établissement, cette hypothèse prise pour ce calcul donne une approximation valable de la réalité. Le temps d'établissement $\tau e$ pris entre 10% et 90% du signal est donc de l'ordre de 2,2 RC, soit 90 nanosecondes, R étant la valeur de la résistance des deux transistors $T_1$ et $T_2$ en parallèle. La

puissance statique dissipée est alors égale à $(VDD)^2/(R_{ON1}\tau \cdot R_{ON2})$ soit $(VDD)^2/R_{ON2}$ soit $15^2/2.10^3 \sim 100$ mW.

b)- pour une alimentation VDD impulsionnelle, on peut choisir une charge $R_{ON2}$ de 10 k$\Omega$ pour avoir le même temps d'établissement que précédemment (résultat expérimental obtenu en conservant le même transistor $T_1$ de sortie que précédemment) ; la puissance statique dissipée comprenant un rapport cyclique de 1/2 pour la pulsation de VDD est alors égale à $(VDD)^2/2R_{ON2} = 10$ mW. On obtient un gain de facteur 10 dans la puissance dissipée par le procédé et le dispositif selon l'invention.

## Revendications

1. Procédé de lecture d'un dispositif à transfert de charge alimenté par une tension continue VDD comportant un étage de sortie qui comprend un élément sur lequel est transféré un signal de charge et un étage suiveur, la lecture s'opérant en deux étapes :
- une première étape de transfert du signal de charge sur l'élément qui va servir à lire ce signal,
- une deuxième étape de lecture proprement dite de ce signal de charge sur cet élément dès que ce signal est établi en sortie de l'étage suiveur ;
caractérisé en ce qu'il consiste à appliquer une tension d'alimentation impulsionnelle ($\varphi$VDD) sur l'étage suiveur de manière à ce que cet étage ne soit alimenté par cette tension impulsionnelle que lors de chacune des deux étapes constituant une lecture.

2. Procédé de lecture selon la revendication 1, caractérisé en ce que la tension impulsionnelle est un signal de phase ($\varphi$VDD) obtenu à partir de la tension continue d'alimentation VDD.

3. Etage de sortie de lecture d'un dispositif à transfert de charge comprenant un élément (DS, Gs) sur lequel est transféré un signal de charge destiné à être lu, et un étage suiveur qui permet la lecture de ce signal et qui comporte un premier transistor MOS ($T_1$) monté en source suiveuse et un deuxième transistor MOS ($T_2$) de charge, caractérisé en ce que cet étage suiveur ($T_1$, $T_2$) est alimenté par une tension impulsionnelle ($\varphi$VDD.

4. Etage de sortie de lecture selon la revendication 3, caractérisé en ce que le transistor de charge ($T_2$) est choisi de sorte qu'il présente une résistance ($R_{ON2}$) élevée de manière à réduire la puissance dissipée sans que pour cela la durée de présence du signal de charge à la sortie de cet étage soit insuffisante.

FIG. 1

FIG. 2

FIG. 3

FIG. 4

FIG. 5

FIG. 6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | RCA REVIEW, vol. 36, no. 3, septembre 1975, pages 566-593, Princeton, N.J., US; W.F. KOSONOCKY et al.: "Basic concepts of charge-coupled devices" * Page 589, lignes 14-30; figures 20,21 * | 1,3 | G 11 C 19/28 |
| A | IEEE JOURNAL OF SOLID-STATE CIRCUITS, vol. SC-13, no. 5, octobre 1978, pages 681-687, IEEE, New York, US; R.C. VARSHNEY et al.: "A block organized 64-kbit CCD memory" * Page 684, lignes 23-53; figure 9 * | 1,3 | |
| A | IEEE JOURNAL OF SOLID-STATE CIRCUITS, vol. SC-11, no. 1, février 1976, pages 10-18, New York, US; S. CHOU: "Design of a 16 384-bit serial charge-coupled memory device" * Page 15, ligne 61 - page 16, ligne 11; figure 8 * | 1,3 | |

**DOMAINES TECHNIQUES RECHERCHES (Int. Cl.4)**

G 11 C 19/00
G 11 C 27/00

Le présent rapport a été établi pour toutes les revendications

| Lieu de la recherche | Date d'achèvement de la recherche | Examinateur |
|---|---|---|
| LA HAYE | 13-07-1989 | GEOGHEGAN C.H.B. |